# EUROPÄISCHE PATENTANMELDUNG

(11) **EP 1 876 547 A1**
(43) Veröffentlichungstag der Anmeldung: **09.01.2008**
(21) Anmeldenummer: 07013201.4
(22) Anmeldetag: 05.07.2007
(51) Int. Cl.: G06F 17/50, G01R 31/28, G01R 19/165

(54) **Verfahren zur Funktionskontrolle von wenigstens einem analogen Schaltungsblock**

(30) Priorität: 05.07.2006 DE 102006031027
(71) Anmelder: ATMEL Germany GmbH, 74072 Heilbronn (DE)
(72) Erfinder: Hiller, Friedrich, 74939 Zuzenhausen (DE)
(74) Vertreter: Müller, Wolf-Christian

(57) **Zusammenfassung**

Es wird ein Verfahren zur Verifikation wenigstens eines Schaltungsblocks (1) oder einer Schaltung (4), die wenigstens zwei miteinander in Verbindung stehende Schaltungsblöcke (5, 6, 7, 8, 9, 10) aufweist, bereitgestellt, bei welchem zur Digitalisierung der Signalwerte innerhalb eines ersten Verifikationsschritts wenigstens eine Leitung (2) am Eingang des Blockes (1.1) mit einem Signal (I, U) beaufschlagt, in einem zweiten Schritt das Signal am Ausgang des Blocks (1.2) auf eine vorgegebene Soll-Funktion überprüft wird, in einem dritten Schritt dem Schaltungsblock (1) bei Erreichen der vorgegebenen Soll-Funktion ein Datenwert und bei Nichterreichen der vorgegebnen Soll-Funktion ein weiterer Datenwert zugeordnet und in einem vierten Schritt der zugeordnete Datenwert mit Angabe des beaufschlagten Schaltungsblocks (1) gespeichert wird.

## Beschreibung

Die vorliegende Erfindung betrifft ein Verfahren zur Verifikation wenigstens eines Schaltungsblocks gemäß Patentanspruch 1, sowie ein Verfahren zur Verifikation von wenigstens zwei miteinander in Verbindung stehenden Schaltungsblöcken innerhalb einer Schaltung gemäß Patentanspruch 3.

Analoge Subsysteme und Schaltungsblöcke stellen in integrierten Schaltungen und Systemen unverzichtbare Funktionen zur Verfügung. Trotz ihres im Vergleich zum digitalen Schaltungsteil kleinen Flächenanteils an der Gesamtfläche der Schaltung verursachen analoge Blöcke einen erheblichen Teil des Entwicklungsaufwands. Der Entwurf von Analogschaltkreisen für Anwendungen bsp. in der Kraftfahrtindustrie erfordert die Einbeziehung externer Komponenten wie Sensoren und Aktuatoren in den Entwicklungsablauf.
Beim Entwurf analoger Systeme lassen sich folgende Abstraktionsebenen unterscheiden: Systemebene; Blockebene, Teilschaltungen und Komponenten.
Ein analoges System stellt einen Schaltungsblock mit einer bestimmten Funktionalität dar, Die Anforderungen an das analoge System ergeben sich aus der Einbettung in das gesamte Mixed-Signal System. Analoge Systeme können in der Größenordnung von einigen Hundert bis mehreren Tausend Transistoren liegen.
Analoge Zellen oder Blöcke sind die Bausteine, aus denen sich ein analoges System zusammensetzt. Ein analoger Block oder eine analoge Zelle nimmt innerhalb des analogen Systems immer nur eine bestimmte Funktion wahr, bsp. Verstärkung, Modulation etc.; für jede Funktion gibt es aber eine Vielzahl von Realisierungen (Topologien). Die Blöcke werden durch ihre Schaltungseigenschaften beschrieben und bestehen typischerweise aus einer überschaubaren Zahl von Transistoren (normalerweise bis zu 50 Transistoren).
Teilschaltungen von der Größe weniger Transistoren stellen die Grundbausteine dar, aus denen ein analoger Block besteht, z.B. Differenzstufe, PTAT. Auf der Komponentenebene (Elektrische Ebene / Transistorebene) wird die Schaltung durch ihre Bauelemente und Konnektivitäten beschrieben. Für die einzelnen Bauelemente existieren im Simulator Modelle, so dass die Schaltung auf der elektrischen Ebene in einem Schaltungssimulator simuliert werden kann.

Ein Analogschaltungsentwurf auf Blockebene ist iterativ und besteht im Wesentlichen aus drei Entwurfsschritten: Topologiegenerierung, Dimensionierung der Elemente der Topologie und Verifikation, ob die Schaltung die Spezifikation erfüllt. Die Topologien werden mit Hilfe eines Schaltplaneditors erstellt oder aus einer Bibliothek bereits vorhandener Topologien ausgewählt. Bei der Dimensionierung sollen für die gegebene Topologie die Parameter der Schaltung (z.B. Längen und Weiten der Transistoren, Kapazitäts- und Widerstandswerte) so eingestellt werden, dass die Schaltung die an sie gestellten Forderungen erfüllt. Zusätzlich sollte die Schaltung so robust wie möglich gegenüber Änderungen der Betriebsumgebung oder Streuungen des Fertigungsprozesses sein.
Die Dimensionierung kann wiederum in zwei Schritte unterteilt werden. Zunächst findet ein Nominalentwurf statt. Dabei wird die Schaltung so dimensioniert, dass sie im Nominalpunkt die an sie gestellten Anforderungen erfüllt. Der Nominalpunkt beschreibt typische Werte der Betriebsparameter und einen typischen Fertigungsprozess. Ergebnis des Nominalentwurfs sollte eine Dimensionierung sein, die einen möglichst guten Ausgangspunkt für eine nachfolgende simulationsintensive Entwurfszentrierung bietet.

Im Anschluss an die Dimensionierung einer Schaltung sollte eine Entwurfszentrierung stattfinden, um die Ausbeute zu verbessern.
Ziel der Entwurfszentrierung ist es, die Schaltung so zu dimensionieren, dass sie robust gegen Einflüsse der Betriebsparameter und Prozessstreuungen ist. Dies bedeutet zugleich eine hohe Ausbeute unter Berücksichtigung von Parameterschwankungen.
Derzeitige Werkzeuge erfordern vom Anwender allerdings in der Regel einen sehr hohen Aufwand, der sich aus zeitaufwändigen Vorbereitungen von Datensätzen und Erarbeiten von Simulationsläufen ergibt. Darüber hinaus sind bei der heutigen Komplexität von Schaltungsentwürfen Analysen mit einem hohen Zeit- und Kostenfaktor verbunden. Eine weitere Herausforderung stellen lokale Parametervariationen dar, deren Einfluss auf das Schaltungsverhalten mit kleiner werdenden Strukturen im Submicron-Bereich immer größer wird.

In der Dissertation "Zur Dimensionierung analoger integrierter Schaltungen unter Berücksichtigung struktureller Nebenbedingungen" von Robert Schwencker (TU München, 13.12.2001) wurde ein simulationsbasiertes Verfahren zum Nominalentwurf und zur Entwurfszentrierung analoger Schaltungsblöcke (mit 10 bis 30 freien Parametern) auf Komponentenebene (Transistorebene) vorgestellt. Die Dimensionierung wurde als mathematisches Optimierproblem formuliert. Die Auswertung der Zielfunktion und die Bestimmung der benötigten Gradienten erfordern in der Regel mehrere Schaltungssimulationen (simulator in a loop) und eine hohe Rechenleistung.

Bekannt sind weiterhin so genannte Top-Down-Entwürfe, mit deren Hilfe eine Spezifikation auf Systemebene in eine Schaltung umgesetzt wird. Diese sind vor allem für digitale Schaltungen weit entwickelt und automatisiert aber auf Analogschaltungen nicht direkt übertragbar, da unter anderem eine wert- und zeitkontinuierliche Analyse erforderlich ist.
Analogentwickler setzen üblicherweise eine Systemspezifikation in eine Schaltung um, indem sie aus ihrer Erfahrung bekannte Grundtopologien auswählen, zusammensetzen und anschließend dimensionieren. Die Dimensionierung wird mittels Berechnungen und iterativen Simulationen dieser Schaltung durchgeführt, bis diese die Spezifikation erfüllt. Das Wissen, eine abstrakte Funktion in eine bestimmte Schaltungstopologie abzubilden, stammt dabei aus langjähriger Erfahrung.
Nach Abschluss des Designs der Analogschaltungen erfolgt deren Kontrolle üblicherweise visuell am Bildschirm über ein Softwaretool, einen so genannte "waveviewer".
Dabei werden riesige Datenmengen erzeugt. Beispielsweise werden bei der Kontrolle eines Oszillatorblocks innerhalb von Simulatonsintervallen, die von wenigen µs bis einigen ms andauern können, tausende von Schwingungen mit jeweils 20 bis 50 Datenwerten pro Schwingung erzeugt.

Bekannt ist auch das folgende Verfahren aus "Computer-Aided Design of Analog and Mixed-Signal Integrated Circuits" von Gielen, G., Rutenbar, R., Proc. IEEE, Vol. 88; Dez. 2000 und "Analog Schaltungssysnthese" von Jores, P., Analog ,96, Berlin, Okt. 1996. Ausgangspunkt ist eine Systemarchitektur, welche die Spezifikation auf Systemebene erfüllt. Die Systemarchitektur stellt eine Signalflussbeschreibung dar, die aus Funktionsblöcken besteht, wobei jeder Block Systemparameter beinhaltet. Um auf Systemebene (nichtkonservativ) eine elektrische Schaltung (konservativ) zu entwickeln, werden zuerst elektrische Randbedingungen auf Systemebene dargestellt. Dazu wird eine elektrische Größe (Strom, Spannung) ausgewählt und auf Systemebene als Signal dargestellt
Nach der Definition der Funktionsblöcke werden die Ein- und Ausgangssignale jedes Funktionsblockes festgelegt. Ein Signal repräsentiert dabei entweder Strom (I) oder Spannung (U). Jeder Funktionsblock kann als ein I/I-, I/U-, U/I- oder U/U-Block umgesetzt werden. Diese Blöcke werden in der sich anschließenden Phase durch Schaltungen ersetzt, deren Verhalten der Funktion des Blockes entspricht ,
Bei der Zusammenschaltung von Blöcken müssen noch Impedanzanpassungen vorgenommen werden und die Pin-Kompatibilität muss überprüft werden. Die Zuweisung geschieht nach dem Prinzip, dass das Verhalten einer Schaltung in einem bestimmten Arbeitsbereich eine mathematische Funktion abbildet. Die Informationen für das Eingangs- und Ausgangsverhalten der für die Blöcke gewählten Topologien in einem bestimmten Arbeitsbereich bestehen aus Randbedingungen der elektrischen Schaltungsebene, wie z.B. Versorgungsspannungen und Arbeitspunkteinstellungen, die der Entwickler festlegen muss.

Bei der Analyse von integrierten Schaltungen tritt jedoch immer wieder die Problematik auf, dass Fehler nicht erkannt werden können, da die Simulation eine bestimmte Konstellation von Schaltungsparametern nicht umfasst hat. Die hohe Komplexität der Schaltungen führt dazu, dass nur spezielle Signale überprüft werden. Aus Zeitgründen wird die Gesamtsimulation der Schaltung auf die wichtigsten Konstellationen beschränkt. Dennoch treten sehr hohe Datenmengen auf, die bei der Auswertung zu bewältigen sind.

Aufgabe der vorliegenden Erfindung ist es daher ein Verfahren bereitzustellen, mit dem die genannten Nachteile im Stand der Technik überwunden werden können.

Diese Aufgabe wird erfindungsgemäß durch ein Verfahren der eingangs genannten Art mit den Merkmalen des Patentanspruches 1 und des Patentanspruchs 3 gelöst. Günstige Ausgestaltungsformen sind Gegenstand von Unteransprüchen.

Demnach besteht das Wesen der Erfindung darin, bei einem Verfahren zur Verifikation eines Schaltungsblockes, der Ein und Ausgabeleitungen für elektrische Signale (I, U) aufweist, innerhalb eines ersten Verifikationsschritts wenigstens eine Leitung am Eingang des Blocks mit einem Signal (I, U) zu beaufschlagen, in einem zweiten Schritt das Signal am Ausgang des Blocks auf eine vorgegebene Soll-Funktion zu überprüfen, in einem dritten Schritt dem Schaltungsblock bei Erreichen der vorgegebenen Soll-Funktion einen Datenwert, insbesondere "1" und bei Nichterreichen der vorgegebenen Soll-Funktion einen weiteren Datenwert, insbesondere "0", zu zuordnen und in einem vierten Schritt den zugeordneten Datenwert mit Angabe des beaufschlagten Schaltungsblocks zu speichern.

Gegenüber einer visuellen Kontrolle des Schaltungsblocks, bei der innerhalb eines Testintervalls eine sehr große Datenmenge anfallen würde, wird bei dem erfindungsgemäßen Verfahren die Datenmenge auf ein Minimum beschränkt. Es wird eine Digitalisierung der Signalwerte vorgenommen, indem jeweils bei Erreichen einer Soll-Funktion ein Datenwert, insbesondere "1", und bei Nichterreichen ein weiterer Datenwert, insbesondere "0", zugeordnet wird.
Beispielsweise kann mit dem Verfahren zunächst getestet werden, ob ein Schaltungsblock überhaupt arbeitet oder nicht. Im vorgenannten Fall wird die Soll-Funktion dann derart definiert werden, dass die Zuordnung des Datenwerts "1" erfolgt, wenn ein Signal, am Ausgang des Schaltungsblocks gemessen werden kann.
Im Gegensatz dazu kann als Soll-Funktion auch ein genau definierter Schwellenwert festgelegt werden, so dass der Datenwert "1" erst dann vergeben wird, wenn dieser bestimmte Schwellenwert, beispielsweise eine bestimmte Amplitude oder eine bestimmte Frequenz bei einem Oszillator erreicht wird. Bei Nichterreichen des definierten Sollwerts wird jeweils der Datenwert "0" zugeordnet. Mögliche Schaltungsblöcke sind dabei auch unter anderen, Operationsverstärker, Band-Gaps, Modulatoren oder Oszillatoren.

In einer Weiterbildung der Erfindung wird ein Verfahren zur Verifikation wenigstens eines Schaltungsblocks innerhalb einer Schaltung, die wenigstens zwei miteinander in Verbindung stehende Schaltungsblöcke aufweist, bereitgestellt. Hierbei weisen die Schaltungsblöcke Leitungen für elektrische Signale (I, U) an den jeweiligen Eingängen und Ausgängen auf, mittels derer die Schaltungsblöcke untereinander in Verbindung stehen. Innerhalb eines ersten Verifikationsschritts wird wenigstens eine Leitung am Eingang eines Schaltungsblockes mit einem Signal, (I, U) beaufschlagt, in einem zweiten Schritt das Signal am Ausgang des Schaltungsblockes, der mit dem Eingang eines weiteren Schaltungsblockes verbunden ist, auf eine vorgegebene Soll-Funktion überprüft, in einem dritten Schritt dem Schaltungsblock bei Erreichen der vorgegebenen Soll-Funktion ein Datenwert, insbesondere "1", und bei Nichterreichen der vorgegebenen Soll-Funktion ein weiterer Datenwert, insbesondere "0", zugeordnet und in einem vierten Schritt der zugeordnete Datenwert mit Angabe des beaufschlagten Schaltungsblockes gespeichert wird.
Dadurch wird ein strukturelles Testverfahren bereitgestellt, bei dem geprüft werden kann, wie ein einzelner Schaltungsblock arbeitet, der mit anderen Schaltungsblöcken gekoppelt ist. Es kann dabei auch festgestellt werden, ob technische Fallgruben bestehen, die bei Testen der gesamten Schaltung im Hinblick darauf, was die Spezifikation erfordert, nicht erkannt werden können. Dort wird nur die Wirkung der gesamten Schaltung festgestellt ohne zu erkennen, wie sie intern arbeitet.
Die Vorteile dieses strukturellen Testverfahrens bestehen darin, dass folgende Effekte, die aufgrund mangelnder Absprache zwischen den Entwicklern auftreten können, erkannt werden können. Wenn beispielsweise an einzelnen Blöcken die Signale eine falsche Polarität aufweisen, am Anschluss der Blöcke Verbindungsfehler gemacht werden oder am Block-Eingang ein falscher Pegel anliegt, kann die Schaltung im betrachteten Bereich die gewünschte Spezifikation aufweisen ohne dass diese strukturellen Fehler erkannt werden. Ursache dafür ist, dass sich durch die langen Simulationszeiten manche Fehler erst sehr spät auswirken oder erst spät an den betrachteten Anschlüssen erkannt werden.

Eine vorteilhafte Weiterbildung der Erfindung sieht weiterhin ein Verfahren zur Verifikation von wenigstens zwei miteinander in Verbindung stehenden Schaltungsblöcken innerhalb einer Schaltung vor, wobei die Schaltungsblöcke Leitungen für elektrische Signale (I, U), an den jeweiligen Eingängen und Ausgängen aufweisen, mittels derer die Schaltungsblöcke untereinander in Verbindung stehen. Bei diesem Verfahren wird zur Verifikation der Schaltungsblöcke innerhalb eines Verifikationsschritts wenigstens eine Leitung am Eingang eines Schaltungsblockes mit einem Signal (I, U) beaufschlagt, in einem zweiten Schritt das Signal am Ausgang eines weiteren Schaltungsblockes auf eine vorgegebene Soll-Funktion überprüft, in einem dritten Schritt den beaufschlagten Schaltungsblöcken bei Erreichen der vorgegebenen Soll-Funktion ein Datenwert, insbesondere "1", und bei Nichterreichen der vorgegebnen Soll-Funktion ein weiterer Datenwert, insbesondere "0", zugeordnet und in einem vierten Schritt der zugeordnete Datenwert mit Angabe der beaufschlagten Schaltungsblöcke gespeichert.
Durch diese Weiterbildung wird ein strukturelles Testverfahren bereitgestellt, bei dem geprüft werden kann, wie die Schaltungsblöcke mit gegenseitiger Einwirkung arbeiten. Es werden dabei mehrere Schaltungsblöcke, die miteinander in Verbindung stehen aktiviert. Hierbei kann festgestellt werden, ob am Anschluss der Blöcke Verbindungsfehler gemacht wurden oder unerwünschte Kopplungseffekte zwischen den Blöcken auftreten.

Eine besonders vorteilhafte Ausgestaltung des Verfahrens besteht darin, bei den genannten Verfahren zur Prüfung der Aktivitätskontrolle wenigstens eines Schaltungsblocks in Abhängigkeit von der Soll-Funktion für die Signale Testparameter in Form von Intervallen mit je einer unteren und einer oberen Grenze zu bilden. Innerhalb eines ersten Verifikationsschritts wird wenigstens eine Leitung am Eingang eines Schaltungsblocks mit einem Signal (I, U) beaufschlagt, in einem zweiten Schritt wird das Signal am Ausgang eines Schaltungsblockes auf die vorgegebenen Intervalle überprüft, in einem dritten Schritt wird dem wenigstens einen Schaltungsblock ein Datenwert, insbesondere "1", zugeordnet, wenn das Signal die untere Grenze des Intervalls durchläuft, und/oder ein weiterer Datenwert, insbesondere "0" zugeordnet, wenn das Signals die oberen Grenze überschreitet oder die untere Grenze nicht erreicht. Schließlich wird der zugeordnete Datenwert in einem vierten Schritt mit Angabe des wenigstens einen beaufschlagten Schaltungsblocks gespeichert.

Durch die Wahl von geeigneten Kriterien in Form von Intervallen, die jeweils bezüglich der oberen und unteren Grenzwerte der geforderten Spezifikation des Schaltungsblocks oder der Schaltungsblöcke entsprechen, kann jeweils festgestellt werden, ob der einzelne Schaltungsblock für sich allein oder in Verbindung mit anderen Schaltungsblöcken stehend die Anforderungen erfüllt.
Aufgrund der Digitalisierung der Signalwerte, werden die auszuwertenden Datenmengen, um ein Vielfaches verringert. Dadurch ist es wiederum möglich, in kürzerer Zeit vielfältige Kombinationen und Konstellationen beim Zusammenwirken von Schaltungsblöcken zu testen.

Gemäß einer Weiterbildung des Verfahrens werden die Schritte "Beaufschlagen einer Leitung am Eingang eines Schaltungsblockes mit einem Signal (I, U)" und "Überprüfung des Signals am Ausgang des Schaltungsblockes auf eine vorgegebene Soll-Funktion" jeweils in einem vorgegebenen Zeitintervall durchgeführt. Dadurch kann festgestellt werden, ob ein Schaltungsblock innerhalb einer vorbestimmten Simulationszeit tatsächlich eingeschaltet wurde, bzw. ob ein bestimmter Schwellenwert erreicht wurde etc.

Weiterhin ist vorgesehen, die Datenwerte in einer Tabelle zu speichern und zu summieren. Dadurch ist es möglich, nach Abschluss der Verifikationsläufe auf einen Blick festzustellen, wie oft ein Schaltungsblock insgesamt an oder eingeschaltet worden ist oder wie oft ein Signal am Ausgang des Schaltungsblocks eine untere oder obere Grenze überschritten hat. Weiterhin ist es möglich sofort zu erkennen, wie oft innerhalb eines vorgegebenen Zeitintervalls eine Soll-Funktion nicht erreicht oder überschritten worden ist.
In einer Weiterbildung der Erfindung ist es vorgesehen, eine Tabelle zu erstellen, in der die Datenwerte und /oder Summen der Datenwerte für alle Schaltungsblöcke der Schaltung gespeichert werden. Dadurch ergibt sich zum einen eine Zusammenstellung aller Schaltungsblöcke unabhängig von ihrer Hierarchie und zum anderen eine Übersicht bzw. eine Testüberdeckung der gesamten Schaltung. Nach Fertigstellung der vorgenannten Tabelle ist auf einen Blick zu erkennen, wie oft ein bestimmter Block innerhalb der Schaltung aktiv bzw. inaktiv war, ob und wie oft eine bestimmte Soll-Funktion erreicht wurde oder wie oft eine untere bzw. obere Grenze einer geforderten Spezifikation überschritten wurde.

Besonders vorteilhaft ist es zur Prüfung der Aktivitätskontrolle jedes einzelnen Schaltungsblockes hinsichtlich des Zeitpunkts des Signalzustands zusätzlich zu jedem Datenwert einen Zeitwert zu speichern. Dadurch lässt sich jeweils erkennen, wann der Schaltungsblock innerhalb des Testintervalls eine Soll-Funktion erreicht oder überschritten hat.
Durch die Vorgabe von Erwartungswerten hinsichtlich des Zeitpunkts kann die korrekte Funktion direkt an einzelnen Blöcken geprüft und bei Fehlern eine Meldung erzeugt werden, durch die der Fehlerort benannt wird. Dadurch wird die Fehlersuche wesentlich vereinfacht.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Anhand der Figuren soll die Erfindung näher beschrieben werden.

Fig. 1 zeigt schematisch einen analogen Schaltungsblock
Fig. 2 zeigt schematisch eine Schaltung mit mehreren analogen Schaltungsblöcken
Fig. 3 zeigt einen ersten Schwingungsverlauf am Ausgang eines Oszillators als Beispiel für einen analogen Schaltungsblock über ein Zeitintervall T1
Fig. 4 zeigt einen Verlauf der zugeordneten Datenwerte "0" und "1" über das Zeitintervall T1 .
Fig. 5 zeigt einen Schwingungsverlauf am Ausgang eines Spannungsreglers über ein Zeitintervall T2
Fig. 6 zeigt einen Verlauf der zugeordneten Datenwerte "0" und "1" über das Zeitintervall T2
Fig. 7 zeigt einen zweiten Schwingungsverlauf am Ausgang eines Spannungsreglers über ein Zeitintervall T3
Fig. 8 zeigt einen Verlauf der zugeordneten Datenwerte "0" und "1" über das Zeitintervall T3
Fig.9 zeigt eine Tabelle mit den gespeicherten und summierten Datenwerten des Schwingungsverlaufs aus Fig. 7
Fig. 10 zeigt einen weiteren Schwingungsverlauf am Ausgang eines Oszillators über ein Zeitintervall T4
Fig. 11 zeigt einen Verlauf der Frequenzen über das Zeitintervall T4
Fig. 12 zeigt einen Verlauf der zugeordneten Datenwerte "0" und "1" über das Zeitintervall T4 .

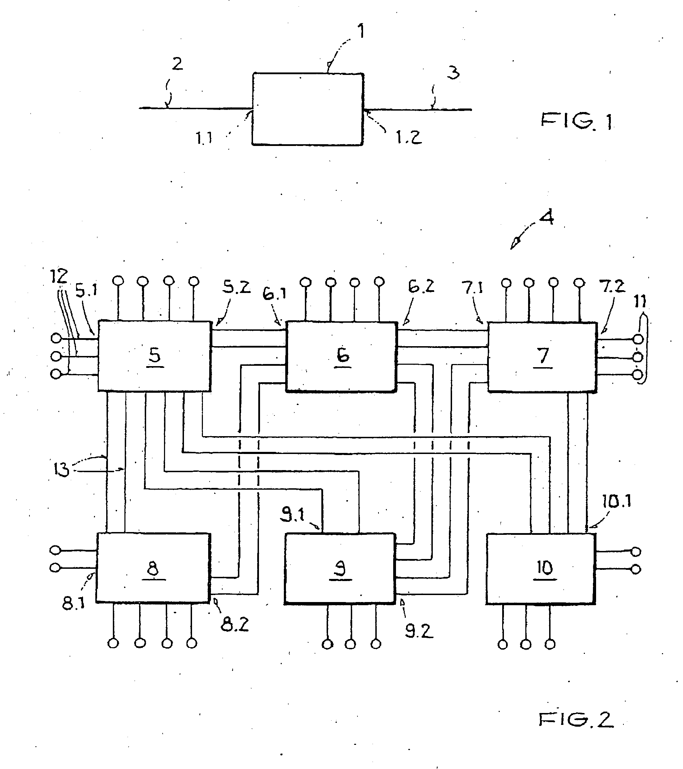

Fig. 1 zeigt schematisch einen analogen Schaltungsblock 1. Es kann sich dabei um Bauteile wie einen Oszillator, ein Band-Gap, ein Modulator, ein Demodulator, ein Phase-locked-loop u.a. handeln. Der Schaltungsblock 1 verfügt über wenigstens einen Eingang 1.1 und wenigstens einen Ausgang 1.2. Zum Eingang 1.1 hin führt eine Leitung 2 und vom Ausgang 1.2 weg führt eine Leitung 3, die jeweils mit einem temporären Signal (I, U) beaufschlagt sein können.

Fig. 2 zeigt schematische eine Schaltung 4 mit mehreren analogen Schaltungsblöcken 5 - 10. Jeder der Schaltungsblöcke 5-10 verfügt jeweils über wenigstens einen Eingang 5.1-10.1 und wenigstens einen Ausgang 5.2-10.2. Weiterhin weist die Schaltung 4 Leitungen 12 auf, die die Schaltung 4 über einen der Schaltungsblöcke 5-10 mit Kontaktflächen 11 verbinden. Über die Kontaktflächen 11 ist es möglich, die Leitungen 12 von außen mit Signalen zu beaufschlagen. Zur Verbindung der Schaltungsblöcke 5-10 untereinander dienen Leitungen 13, die jeweils den Ausgang eines Schaltungsblocks 5.2-10.2 mit einem Eingang eines weiteren Schaltungsblocks 5.1-10.1 verbinden.

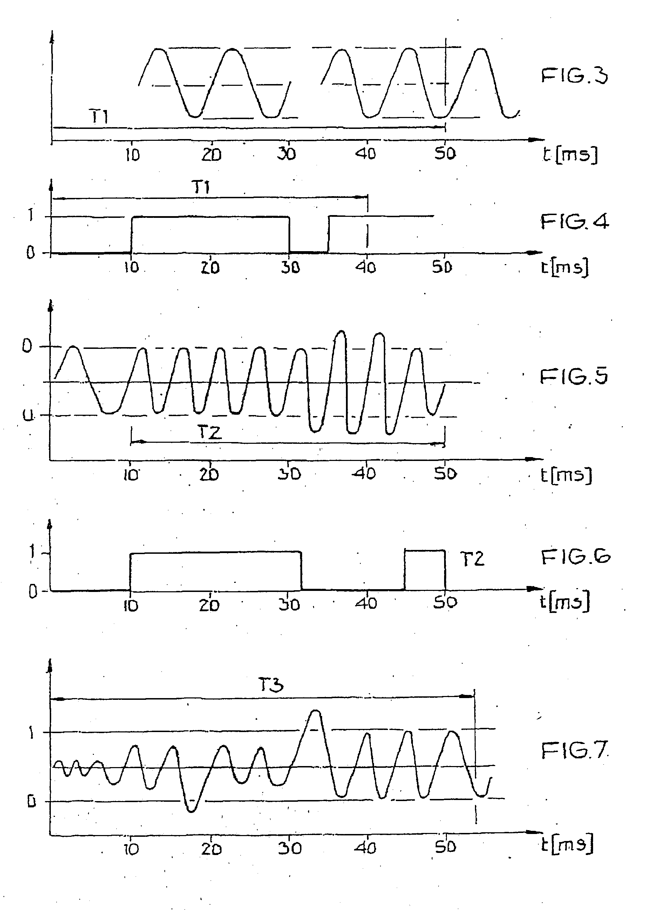

Fig. 3 zeigt einen ersten Schwingungsverlauf am Ausgang eines Oszillators als Beispiel für einen analogen Schaltungsblock über ein Zeitintervall T1 Während des Zeitintervalls T1 wird getestet, ob der Oszillator überhaupt anfängt zu schwingen, nachdem er von außen angeregt worden ist. Der Verlauf der Schwingung zeigt an, dass nach 10 ms eine Schwingung eingesetzt hat. Nach 30ms wurde die Schwingung unterbrochen, nach 35ms setzte die Schwingung wieder ein. In den Zeitintervallen von 0 bis 10 ms und von 30 bis 35ms wurde am Ausgang des Oszillators keine Schwingung gemessen.

Fig. 4 zeigt dementsprechend einen Verlauf der zugeordneten Datenwerte "0" und "1" über das Zeitintervall T1. Solange kein Signal am Ausgang des Oszillators gemessen wird, nimmt, wird diesem Signal der Datenwert "0" zugeordnet. Nach 10ms ist die definierte Soll-Funktion, nämlich das Auftreten eines Signals erreicht und dem Signalwert wird der Daten wert "1" zugeordnet.

Auch die Fig. 5 und Fig. 7 zeigen einen Signalverlauf am Ausgang eines Spannungsreglers, über ein Zeitintervall T2 bzw. T3. Bei diesem Verifikationslauf soll getestet werden, ob die Spannungen während eines vorgegebenen Zeitintervalls in einem bestimmten Amplitudenbereich liegen. Für den vorgegebenen Amplitudenbereich ist ein Intervall mit einer oberen Grenze O und einer unteren Grenze U definiert.

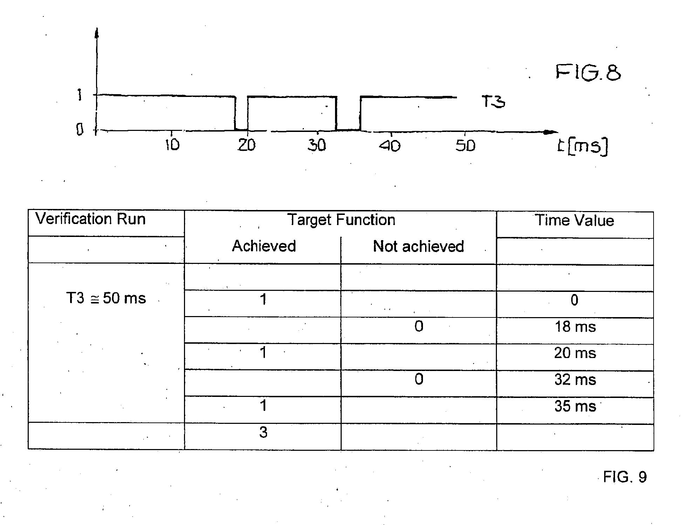

Die Fig. 6 und Fig. 8 zeigen jeweils den Verlauf der zugeordneten Datenwerte "0" und "1" über das Zeitintervall T2 und T3. Solange die Werte der Spannungen innerhalb des definierten Intervalls liegen, wird dem Signal der Datenwert "1" zugeordnet. Unterschreitet das Signal die untere Grenze U oder überschreitet das Signal die obere Intervallgrenze O wird ein Datenwert "0" zugeordnet. Bei der Auswertung der Datenwerte lässt sich somit auf einen Blick erkennen, dass die Spannungen am Spannungsregler den definierten Bereich mehrmals verlassen haben.

Fig.9 zeigt eine Tabelle mit den gespeicherten und summierten Datenwerten des Signalverlaufs aus Fig. 7. Anhand der Tabelle wird der graphische Verlauf der Datenwerte in eine numerische Form gebracht. Ein Datenwert "0" oder "1" wird jeweils hinzugefügt, wenn eine Änderung im Signalverlauf in der Art eintritt, dass die obere oder untere Grenze einer Soll-Funktion, also eines spezifizierten Intervalls, über- bzw. unterschritten worden ist. Anhand der Summe der Datenwerte lässt sich sofort erkennen, wie oft ein unerwünschter Wechsel im Signalverlauf während eines Testintervalls eingetreten ist. Die Summe der Datenwerte wird anschließend für alle getesteten Schaltungsblöcke bzw. für alle getesteten Ausgänge der Schaltungsblöcke in eine weitere Tabelle übertragen. Die abschließende Tabelle gibt danach einen Überblick über die Testüberdeckung der gesamten Schaltung.

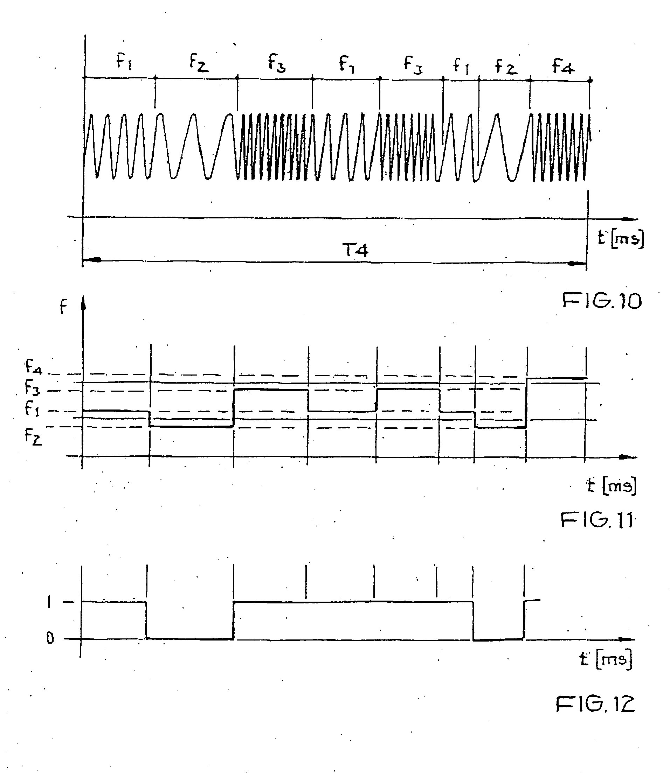

Fig. 10 zeigt einen weiteren Schwingungsverlauf am Ausgang eines Oszillators über ein Zeitintervall T4. Bei diesem Verifikationslauf soll getestet werden, ob die Schwingungen während eines vorgegebenen Zeitintervalls in einem bestimmten Frequenzbereich liegen.

Fig. 11 zeigt den zugehörigen Verlauf der Frequenzen aus Fig. 10 über das Zeitintervall T4. Für den vorgegebenen Frequenzbereich ist ein Intervall mit einer oberen Grenze O und einer unteren Grenze U definiert. Hierbei handelt es sich um einen Zwischenschritt.

In Fig. 12 ist dementsprechend der Verlauf der zugeordneten Datenwerte "0" und "1" über das Zeitintervall T4 dargestellt. Solange die Werte der Frequenzen innerhalb des definierten Intervalls liegen, wird dem Signal der Datenwert "1" zugeordnet. Unterschreitet das Signal die untere Grenze U oder überschreitet das Signal die obere Intervallgrenze O wird ein Datenwert "0" zugeordnet. Auch hier lässt sich nun sofort erkennen, wann der Oszillator im Sollbereich gearbeitet hat.

## Patentansprüche

1. Verfahren zur Verifikation wenigstens eines Schaltungsblocks (1),
• wobei
• der Schaltungsblock (1) Leitungen (2, 3) für elektrische Signale (I, U) am Eingang (1.1) und Ausgang (1.2) des Blocks aufweist,
• innerhalb eines ersten Verifikationsschritts wenigstens eine Leitung (2) am Eingang des Blockes (1.1) mit einem Signal (I, U) beaufschlagt und
• in einem zweiten Schritt das Signal am Ausgang des Blocks (1.2) auf eine vorgegebene Soll-Funktion überprüft wird,
• in einem dritten Schritt dem Schaltungsblock (1) bei Erreichen der vorgegebenen Soll-Funktion ein Datenwert, insbesondere "1" , und bei Nichterreichen der vorgegebnen Soll-Funktion ein weiterer Datenwert, insbesondere "0", zugeordnet und
• in einem vierten Schritt der zugeordnete Datenwert mit Angabe des beaufschlagten Schaltungsblocks (1) gespeichert wird.

2. Verfahren zur Verifikation wenigstens eines Schaltungsblocks (5) innerhalb einer Schaltung (4), die wenigstens zwei miteinander in Verbindung stehende Schaltungsblöcke (5, 6, 7, 8, 9, 10) aufweist,
• wobei die Schaltungsblöcke (5, 6, 7, 8, 9, 10) Leitungen (2, 3) für elektrische Signale (I, U) an den jeweiligen Eingängen (5.1, 6.1, 7.1, 8.1, 9.1, 10.1) und Ausgängen (5.2, 6.2, 7.2, 8.2, 9.2, 10.2) aufweisen,
• die Schaltungsblöcke (5, 6, 7, 8, 9, 10) mittels der Leitungen (2, 3) untereinander in Verbindung stehen, und
• innerhalb eines ersten Verifikationsschritts wenigstens eine Leitung (2, 3) am Eingang eines Schaltungsblockes (5.1) mit einem Signal (I, U) beaufschlagt ,
• in einem zweiten Schritt das Signal am Ausgang des Schaltungsblockes (5.2), der mit dem Eingang eines weiteren Schaltungsblockes (6.1, 8.1, 9.1, 10.1) verbunden ist, auf eine vorgegebene Soll-Funktion überprüft,
• in einem dritten Schritt dem Schaltungsblock (5) bei Erreichen der vorgegebenen Soll-Funktion ein Datenwert, insbesondere "1", und bei Nichterreichen der vorgegebnen Soll-Funktion ein weiterer Datenwert, insbesondere "0", zugeordnet und
• in einem vierten Schritt der zugeordnete Datenwert mit Angabe des beaufschlagten Schaltungsblockes (5) gespeichert wird.

3. Verfahren zur Verifikation von wenigstens zwei miteinander in Verbindung stehenden Schaltungsblöcken (5, 6, 7, 8, 9, 10) innerhalb einer Schaltung (4),
• wobei die Schaltungsblöcke (5, 6, 7, 8, 9, 10) Leitungen (2, 3) für elektrische Signale (I, U) an den jeweiligen Eingängen (5.1, 6.1, 7.1, 8.1, 9.1, 10.1) und Ausgängen (5.2, 6.2, 7.2, 8.2, 9.2, 10.2) aufweisen,
• die Schaltungsblöcke mittels der Leitungen (2, 3) untereinander in Verbindung stehen, und
• innerhalb eines ersten Verifikationsschritts wenigstens eine Leitung am Eingang eines Schaltungsblockes (5.1) mit einem Signal (I, U) beaufschlagt,
• in einem zweiten Schritt das Signal am Ausgang eines weiteren Schaltungsblockes (6.2, 7.2, 8.2, 9.2) auf eine vorgegebene Soll-Funktion überprüft,
• in einem dritten Schritt den beaufschlagten Schaltungsblöcken (5, 6, 7, 8, 9, 10) bei Erreichen der vorgegebenen Soll-Funktion ein Datenwert, insbesondere "1", und bei Nichterreichen der vorgegebnen Soll-Funktion ein weiterer Datenwert, insbesondere "0", zugeordnet und
• in einem vierten Schritt der zugeordnete Datenwert mit Angabe der beaufschlagten Schaltungsblöcke (5, 6, 7, 8, 9, 10) gespeichert wird.

4. Verfahren gemäß einem der vorhergehenden Ansprüche, **dadurch gekennzeichnet, dass** zur Prüfung der Aktivitätskontrolle wenigstens eines Schaltungsblocks in Abhängigkeit von der Soll-Funktion für die Signale Testparameter in Form von Intervallen mit je einer unteren und einer oberen Grenze gebildet werden, so dass
• innerhalb eines ersten Verifikationsschritts wenigstens eine Leitung (2, 3) am Eingang eines Schaltungsblockes (1.1, 5.1, 6.1, 7.1, 8.1, 9.1, 10.1) mit einem Signal (I, U) beaufschlagt,
• in einem zweiten Schritt das Signal am Ausgang eines Schaltungsblockes (1.2, 5.2, 6.2, 7.2, 8.2, 9.2, 10.2) auf die vorgegebenen Intervalle überprüft,
• in einem dritten Schritt dem wenigstens einen Schaltungsblock (1, 5, 6, 7, 8, 9, 10) ein Datenwert, insbesondere "1", zugeordnet wird, wenn das Signal die untere Grenze des Intervalls überschreitet, und ein weiterer Datenwert, insbesondere "0", zugeordnet wird, wenn das Signals die oberen Grenze überschreitet oder die untere Grenze nicht erreicht,
• in einem vierten Schritt der zugeordnete Datenwert mit Angabe des wenigstens einen beaufschlagten Schaltungsblocks (1, 5, 6, 7, 8, 9, 10) gespeichert wird.

5. Verfahren gemäß einem der vorhergehenden Ansprüche, **dadurch gekennzeichnet, dass** die Schritte eins und zwei jeweils in einem vorgegebenen Zeitintervall durchgeführt werden.

6. Verfahren gemäß einem der vorhergehenden Ansprüche, **dadurch gekennzeichnet, dass** die Datenwerte in einer Tabelle gespeichert und summiert werden.

7. Verfahren gemäß Anspruch 6, **dadurch gekennzeichnet, dass** die Summe der Datenwerte für den beaufschlagten Schaltungsblock oder die beaufschlagten Schaltungsblöcke in einer weiteren Tabelle gespeichert werden.

8. Verfahren gemäß einem der vorhergehenden Ansprüche, **dadurch gekennzeichnet, dass** zur Prüfung der Aktivitätskontrolle jedes einzelnen Schaltungsblockes (1, 5, 6, 7, 8, 9, 10) hinsichtlich des Zeitpunkts des Signalzustands zu jedem Datenwert ein Zeitwert gespeichert wird.
